(19) Europäisches Patentamt
European Patent Office
Office européen des brevets

(11) Publication number : **0 308 000 B1**

# (12) EUROPEAN PATENT SPECIFICATION

(45) Date of publication of patent specification : **29.05.91 Bulletin 91/22**

(51) Int. Cl.$^5$ : **H03F 3/45**

(21) Application number : **88201898.9**

(22) Date of filing : **05.09.88**

## (54) Amplifier arrangement.

(30) Priority : **14.09.87 NL 8702177**

(43) Date of publication of application : **22.03.89 Bulletin 89/12**

(45) Publication of the grant of the patent : **29.05.91 Bulletin 91/22**

(84) Designated Contracting States : **DE FR GB IT NL**

(56) References cited :
**FR-A- 2 588 707**
**US-A- 4 477 782**
**IEEE JOURNAL OF SOLID-STATE CIRCUITS, vol. SC-22, no. 3, June 1987, pages 330-334, IEEE, New York, US; J.A.FISHER et al.: "A highly linear CMOS buffer amplifier"**

(56) References cited :
**IEEE JOURNAL OF SOLID-STATE CIRCUITS, vol. SC-17, no. 6, December 1982, pages 969-982, IEEE, New York, US; P.R.GRAY et al.: "MOS operational amplifier design - A tutorial overview"**
**ELECTRONICS, vol. 44, no. 2, 18th January 1971, pages 81-84, New York, US; D.C.WYLAND: "FET cascode technique optimizes differential amplifier performance"**

(73) Proprietor : **N.V. Philips' Gloeilampenfabrieken**
**Groenewoudseweg 1**
**NL-5621 BA Eindhoven (NL)**

(72) Inventor : **Boudewijns, Arnoldus Johannes Juliana**
**c/o Int. Octrooibureau B.V. Prof. Holstlaan 6**
**NL-5656 AA Eindhoven (NL)**

(74) Representative : **Peters, Rudolf Johannes et al**
**INTERNATIONAAL OCTROOIBUREAU B.V.**
**Prof. Holstlaan 6**
**NL-5656 AA Eindhoven (NL)**

EP 0 308 000 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

The invention relates to an amplifier arrangement comprising a differential amplifier having two input terminals for receiving an input voltage and a differential-to-single-ended converter having an output terminal for supplying an output current, said converter including a first and a second transistor of a first conductivity type whose source electrodes are coupled to a first supply terminal and whose gate electrodes are coupled together, and a third and a fourth transistor of the first conductivity type arranged in cascode with the first and the second transistor, respectively, and having their gate electrodes coupled together, the gate electrode of the first transitor being coupled to the drain electrode of the third transistor, said differential amplifier including a fifth and a sixth transistor of a second conductivity type opposite to the first conductivity type whose gate electrodes are coupled to the input terminals and whose source electrodes are coupled to a common terminal which is coupled by means of a first current source to a second supply terminal, and a seventh and a eighth transistor of the second conductivity type which are arranged in cascode with the fifth and the sixth transistor respectively, the arrangement also including a bias circuit for biassing the gate electrodes of the third and the fourth transistor at a voltage which is substantially equal to the sum of one threshold voltage and two saturation voltages, said bias circuit including a ninth transistor of the first conductivity type whose source electrode is coupled to the first supply terminal and whose gate electrode is coupled to the common gate electrode of the third and fourth transistor and to its drain electrode.

An amplifier arrangement of this type can be generally used as an operational amplifier having a relatively high gain and a relatively large bandwidth. Such an arrangement can be particularly used in video circuits, switched capacitor circuits and sample and hold circuits.

Such an amplifier arrangement is known from the US Patent 4,477,782 Figure 3.

In this known amplifier arrangement the current through the ninth transistor is supplied by a further transistor of the second conductivity type having its source connected to the junction point of the drain of the fifth transistor and the source of the seventh transistor and having its interconnected gate and drain electrodes connected to both the gates of the seventh and eighth transistor and to the interconnected gate and drain electrodes of the ninth transistor. The further and the seventh transistor have equal dimensions in order to assure equal currents to flow in the branch constituted by the ninth transistor and the branch constituted by the third and the first transistor. By proper selection of the dimensions of the transistors in the differential-to-single-ended converter the gate electrodes of the third and fourth transistor are biassed at a voltage which is substantially equal to the sum of one threshold voltage and two saturation voltages. The output terminal can then be driven up to two saturation voltages with respect to the voltage at the first supply terminal. This yields, particularly at low supply voltages, a wide voltage swing at the output terminal. This known current supply to the ninth transistor has several drawbacks. It limits to an amplifier arrangement in which the gate electrodes of the cascode arranged seventh and eighth transistor are interconnected and biassed at the same voltage as the gates of the third, fourth and ninth transitor. The known current supply is also dependent on the signal current and is not fixed. A third drawback is that the currents in both main signal current branches are not equal any more. This causes offset which has to be compensated for by proper selection of the dimensions of the fourth and second transistor. This complicates the design and reduces the accuracy of the amplifier arrangement.

It is an object of the invention to provide an amplifier arrangement not having the afore-mentioned drawbacks. According to the invention an amplifier arrangement of a type described in the opening paragraph is characterized in that the drain electrode of the ninth transistor is coupled to the second supply terminal by means of a second current source.

The ninth transistor is directly biassed from the second power supply terminal by means of the second current source. The current intensity of this source and the dimensions of the ninth transistor are selected to be such that the gate-source voltage of the ninth transistor is substantially equal to the sum of the threshold voltage and the saturation voltage of the fourth transistor and the saturation voltage of the second transistor. This bias is fixed, independent of signal current, enables different biassing methods for the gate electrodes of the cascode arranged seventh and eighth transistors and allows equal dimensions in all transistors of the dual-to-single-converter yielding a simpler and more accurate amplifier arrangement.

A first embodiment of an amplifier arrangement according to the invention may further be characterized in that a tenth transistor of the first conductivity type is arranged in series with the ninth transistor, the gate electrode of the ninth transistor being coupled to the gate electrode and to the drain electrode of the tenth transistor. The ninth transistor will be generally biassed at a lower current than the second and fourth transistors in order to obtain a low dissipation. To realise the desired bias voltage the channel length of the ninth transistor should be larger than that of the second and fourth transistors. The spread in the channel length of transistors occurring due to process variations thereby influences the gate-source voltage of the ninth transistor and hence the bias voltage in a different way than the gate-source voltages of the second and fourth transistor. By splitting the ninth transistor into two transistors, e.g. the ninth and the tenth transistor, each having a shorter channel length, the bias voltage variations occurring due to process variations are substantially equal to the variations of the voltages of the second and fourth transistors so that the minimum output voltage at the output terminal has become substantially independent of these process variations.

A second embodiment of an amplifer arrangement according to the invention may be characterized in that the gate electrodes of the seventh and the eighth transistor are coupled together and in that an eleventh transistor of the second conductivity type is arranged between the common terminal of the source electrodes of the fifth and the sixth transistor and the common gate electrode of the seventh and the eighth transistor, the drain of the eleventh transistor being connected to the eleventh transistor's gate electrode and to the first supply terminal by means of a third current source. The gate electrodes of the seventh and the eighth transistor are biassed by means of the eleventh transistor at a substantially fixed voltage with respect to the common terminal of the source electrodes of the fifth and sixth transistor.

A further embodiment may be characterized in that a twelfth transistor of the first conductivity type is arranged in series with the eleventh transistor, said twelfth transistor having its source electrode coupled to the common gate electrode of the seventh and the eighth transistor and having its gate electrode coupled to the second supply terminal. Due to the twelfth transistor the voltage difference between the common terminal of the source electrodes of the fifth and the sixth transistor and the coupled gate electrode of the seventh and the eighth transistor remain substantially constant over a large input d.c. voltage range.

A suitable further embodiment may be characterized in that the third current source is constituted by a thirteenth transistor of the first conductivity type whose source electrode is coupled to the first supply terminal and whose gate electrode is coupled to the gate electrode of the ninth transistor.

A third embodiment of an amplifier arrangement according to the invention may be characterized in that the arrangement is formed as an integrated circuit on a substrate of a first conductivity type in which the fifth and the sixth transistors are arranged in a zone of a second conductivity type which is connected to the second supply terminal and in which the seventh and the eighth transistors are arranged in separate, zones of the second conductivity type which are connected to the drain electrodes of the fifth and the sixth transistor, respectively, and in that the gate electrodes of the seventh and eighth transistor are connected to the gate electrodes of the fifth and the sixth transistor, respectively. In this embodiment the so-called back-gate effect is used according to which the threshold voltage of a transistor increases as the bulk voltage increases. By connecting the zone in which the fifth and the sixth transistors are formed to a higher voltage than the zones in which the seventh and the eighth transistors are formed, the fifth and the sixth transistors acquire a higher threshold voltage than the seventh and the eighth transistors. This difference is so large that the gate electrodes of the seventh and the eighth transistors can be connected without any problem to the gate electrodes of the fifth and the sixth transistors.

A fourth embodiment of an amplifier arrangement according to the invention in which this back-gate effect is also used may be characterized in that the arrangement is formed as an integrated circuit on a substrate of a first conductivity type in which the fifth and the sixth transistors are arranged in a zone of the second conductivity type which is connected to the second supply terminal and in which the seventh and the eighth transistors are arranged in a common zone of the second conductivity type which is connected to the common terminal of the source electrodes of the fifth and the sixth transistors, and in that the gate electrodes of the seventh and the eighth transistors are connected to the gate electrode of the fifth and the sixth transistors, respectively.

The invention will now be described in greater detail by way of example with reference to the accompanying drawings in which

Fig. 1 shows a first embodiment of an amplifier arrangement according to the invention,

Fig. 2 shows a second embodiment of an amplifier arrangement according to the invention,

Fig. 3 shows a third embodiment of an amplifier arrangement according to the invention,

Fig. 4 shows a fourth embodiment of an amplifier arrangement according to the invention,

Fig. 5 shows a fifth embodiment of an amplifier arrangement according to the invention, and

Fig. 6 shows a sixth embodiment of an amplifier arrangement according to the invention.

Corresponding components have the same reference numerals in these Figures.

Fig. 1 shows a first embodiment of an amplifier arrangement according to the invention. It comprises two P-channel transistors $T_7$ and $T_8$ arranged as a differential pair whose common source terminal 6 is connected to the positive supply terminal 2 by means of a current source $I_1$. The gate electrodes of transistors $T_7$ and $T_8$ are connected to input terminals 3 and 4 for receiving an input voltage. Two P-channel transistors $T_9$ and $T_{10}$ are arranged in cascode with transistors $T_7$ and $T_8$, respectively. The transistors $T_9$ and $T_{10}$ have a common gate electrode which is maintained at a substantially fixed voltage with respect to the so-called common-mode voltage at the common source terminal 6 by means of a P-channel transistor $T_{11}$ whose drain electrode is connected to the gate electrode and to the negative supply terminal 1, in this embodiment ground, by means of a current source $I_3$.

A signal voltage applied between the input terminals 3 and 4 is converted by the differential amplifier $T_7$-$T_{10}$ into two phase opposed signal currents which can in principle be taken from the drain electrodes of the transistors $T_9$ and $T_{10}$. As is known, the cascode transistors $T_9$ and $T_{10}$ increase the bandwidth of the amplifier arrangement because the Miller effect of the drain-gate capacitance of the transistors $T_7$ and $T_8$ is eliminated. Besides, the output impedance and hence the gain of the amplifier arrangement is increased thereby.

The drain electrode of transistor $T_9$ is coupled to both the drain electrode of transistor $T_{10}$ and to the output terminal 5 of the amplifier arrangement by means of a differential-to-single-ended converter 10 which converts the differential signal currents in the drain leads of transistors $T_9$ nand $T_{10}$ into a single-ended output current at output terminal 5. The converter 10 has two N-channel transistors $T_1$ and $T_2$ whose source electrodes are connected to the supply terminal 1 and whose gate electrodes are connected together and to the drain electrode of transistors $T_9$. Two N-channel transistors $T_3$ and $T_4$ are arranged in cascode with transistors $T_1$ and $T_2$, respectively. The gate electrodes of these transistors are connected together and are biassed at a fixed voltage with respect to ground by means of a bias circuit. This circuit is constituted by an N-channel transistor $T_5$ whose source electrode is connected to ground and whose gate electrode is connected to the drain electrode and to the common gate electrode of transistors $T_3$ and $T_4$. The drain electrode of transistor $T_5$ is connected to the positive supply terminal 2 by means of a current source $I_2$. The transistors $T_1$ and $T_2$ of the converter 10 constitute a current mirror which mirrors the current flowing through transistor $T_4$. The d.c. component therein compensates the d.c. component of the current through transistor $T_{10}$, whilst the phase-opposed signal currents result in an output signal current which is twice as large. Due to the cascode transistors $T_4$ and $T_{10}$ the amplifier arrangement acquires a high output impedance and hence a large gain. Moreover, the cascode transistors $T_4$ and $T_{10}$ eliminate the Miller effect of the drain-gate capacitance which is otherwise present between the output terminal 5 and the gate electrode of transistor $T_2$ and the gate electrode of transistor $T_8$, respectively. Consequently the amplifier arrangement acquires a large bandwidth. The transistors $T_3$ and $T_9$ render the arrangement symmetrical and decrease the d.c. offset at the output.

The current intensity of the current source $I_2$ and the dimensions of transistor $T_5$ are chosen to be such that the gate-source voltage of transistor $T_5$ is substantially equal to the sum of the threshold voltage and the saturation voltage of transistor $T_4$ and the saturation voltage of transistor $T_2$. The saturation voltage is the minimum drain- source voltage which is required to bias a transistor in its saturation range. Since the gate-source voltage of transistor $T_4$ is equal to the sum of its threshold voltage and its saturation voltage, the voltage at the source electrode of transistor $T_4$ is then at least equal to the saturation voltage of transistor $T_2$ so that the voltage at the output terminal 5 can become at least equal to the sum of the saturation voltages of transistor $T_2$ and $T_4$. The output terminal 5 may therefore be driven up to two saturation voltages, that is to say, up to substantially 400 mV of the negative supply terminal 1 without a loss of gain.

Fig. 2 shows a second embodiment of an amplifier arrangement according to the invention. The bias circuit for biassing the common gate electrode of transistors $T_3$ and $T_4$ now includes and N-channel transistor $T_6$ which is arranged in series with transistor $T_5$ and whose drain electrode is connected to its gate electrode and to the gate electrode of transistor $T_5$. In the arrangement of Fig. 1 transistor $T_5$ will be generally biassed at a lower current than the transistors $T_2$ and $T_4$ in order to obtain a low dissipation. To realise the desired bias voltage the channel length of transistor $T_5$ should be larger than that of transistors $T_2$ and $T_4$. The spread in the channel length of the transistors occuring due to the process variation thereby influences the gate-source voltage of transistor $T_5$ and hence the bias voltage in a different way than the gate-source voltages of transistor $T_4$ and transistor $T_2$. By splitting transistor $T_5$ into two transistors $T_5$ and $T_6$ each having shorter channel lengths, the bias voltage variations occuring due to process variations are substantially equal to the variations of the voltages of the transistors $T_2$ and $T_4$ so that the minimum ouput voltage swing has become substantially independent of these process variations.

In this embodiment current source $I_3$ is formed advantageously by an N-channel transistor $T_{13}$ whose source is connected to ground terminal 1 and whose gate electrode is connected to the gate electrode of transistor $T_5$ which is at a fixed voltage with respect to ground.

Fig. 3 shows a third embodiment of an amplifier arrangement according to the invention. In this embodiment the series arrangement of a P-channel transistor $T_{11}$ whose gate electrode is connected to the drain electrode and an N-channel transistor $T_{12}$ whose gate electrode is connected to the positive supply terminal 2 is arranged between the common source terminal 6 and the common gate electrode of the transistors $T_9$ and $T_{10}$. The common gate electrode of the transistors $T_9$ and $T_{10}$ is maintained by this arrangement at a fixed voltage with respect to the terminal 6 over a large input d.c. voltage range. In face, the gate-source voltage variations of transistor $T_{11}$ occurring in the case of input d.c. voltage variations are compensated by oppositely occurring variations of the drain-source voltage of transistor $T_{12}$ so that the sum of these voltages remains substantially constant.

Fig. 4 shows a fourth embodiment of an amplifier arrangement according to the invention. In this embodiment it is not necessary to use a separate bias circuit to bias the common gate electrode of the transistors $T_9$ and $T_{10}$ at a substantially fixed voltage with respect to the terminal 6, but the gate electrodes of transistors $T_9$ and $T_{10}$ are connected to the gate electrodes of transistors $T_7$ and $T_8$, respectively. In this arrangement use is made of the so-called back-gate effect which causes the threshold voltage of a transistor to increase as the voltage between the source electrode and the bulk material in which the transistor is formed increases. In this embodiment the arrangement is integrated on a P-type substrate. The transistors $T_7$ and $T_8$ are formed in an N-well 20 which is connected to the positive supply terminal 2 and the transistors $T_9$ and $T_{10}$ are formed in N-wells 30 and 40 which are connected to the source electrode of the relevant transistor. Since the source-bulk voltage of transistors $T_7$ and $T_8$ is high and that of transistors $T_9$ and $T_{10}$ is zero, the threshold voltage of transistors $T_7$ and $T_8$ is larger than that of transistors $T_9$ and $T_{10}$. The difference between these threshold voltages is present between the source and drain electrodes of transistors $T_7$ and $T_8$. Although the source-bulk voltage of transistors $T_7$ and $T_8$ is dependent on the input d.c. voltage, this voltage difference is sufficiently large over a relatively large range to drive transistors $T_7$ and $T_8$ into saturation so that these transistors can convey a sufficiently large current. The threshold voltage of transistors $T_7$ and $T_8$ is, for example substantially equal to 1.4 V over a relatively large range, whilst the threshold voltage of transistors $T_9$ and $T_{10}$ is equal to 1.0 Volt.

Fig. 5 shows a fifth embodiment of an amplifier arrangement according to the invention. In this embodiment the transistors $T_9$ and $T_{10}$ are not arranged in separate N-wells but in one common N-well 40 which is connected to the common source terminal 6. The gate electrodes of transistors $T_9$ and $T_{10}$ are again connected to the gate electrodes of transistors $T_7$ and $T_8$. In this embodiment both the source-bulk voltage of the transistors $T_7$ and $T_8$ and the source-bulk voltage of the transistors $T_9$ and $T_{10}$ is dependent on the input d.c. voltage. The source-bulk voltage of transistors $T_7$ and $T_8$ is then larger than the source-bulk voltage of the transistors $T_9$ and $T_{10}$ so that the threshold voltage of transistors $T_7$ and $T_8$ is always larger than that of transistors $T_9$ and $T_{10}$. The difference between these voltages is present between the source and drain electrodes of transistors $T_7$ and $T_8$ and is larger than the saturation voltage of these transistors over a relatively reasonably large range of the input d.c. voltage so that these transistors can convey a relatively large current. The arrangement of Fig. 5 is built up very symmetrically. This arrangement is very suitable for use as a buffer amplifier.

Fig. 6 shows a sixth embodiment of an amplifier arrangement according to the invention. In this embodiment the transistors $T_9$ and $T_{10}$ are arranged in a common N-well 40 which is connected to the common terminal 6 of the source electrodes of the transistors $T_7$ and $T_8$. The gate electrodes of the transistors $T_9$ and $T_{10}$ are interconnected and are connected to the gate electrode of input transistor $T_7$. This arrangement substantially has the same properties as the arrangement of Fig. 5, but it is built up less symmetrically. The amplifier arrangement of Fig. 6 is particularly suitable for use in an inverting amplifier in which a first capacitor is connected to the input 4 and a second capacitor is arranged between the input 4 and the output 5. If the arrangement of Fig. 5 is used in such an amplifier, the drain-gate capacitance of transistor $T_{10}$ influences the gain. When using the arrangement of Fig. 6 in such an amplifier, this effect does not occur and the gain is only determined by the first and the second capacitor.

The invention is not limited to the embodiments shown and many variations within the scope of the invention are possible to those skilled in the art. The bias circuit for biassing the common gate electrode of the transistors $T_3$ and $T_4$ may be formed in any other way than in the manners shown, provided that this voltage is at least equal to the sum of one threshold voltage and two saturation voltages. The differential amplifier may also be built up in any other way than in the manner shown. In the embodiments of Fig. 5 and 6 the common N-well of the transistors $T_9$ and $T_{10}$ may in principle also be connected to the source electrode of transistor $T_9$. Finally, the amplifier arrangement may of course also be formed with transistors of the opposite conductivity type.

## Claims

1. An amplifier arrangement comprising a differential amplifier having two input terminals for receiving an input voltage and a differential-to-single-ended converter having an output terminal for supplying an output current, said converter including a first and a second transistor of a first conductivity type whose source electrodes are coupled to a first supply terminal and whose gate electrodes are coupled together, and a third and a fourth transistor of the first conductivity type arranged in cascode with the first and the second transistor, respectively, and having their gate electrodes coupled together, the gate electrode of the first transistor being coupled to the drain electrode of the third transistor, said differential amplifier including a fifth and a sixth transistor of a second conductivity type opposite to the first conductivity type whose gate electrodes are coupled to the input terminals and whose source electrodes are coupled to a common terminal which is coupled by means of a first current source to a second supply terminal, and a seventh and a eighth transistor of the second conductivity type which are arranged in cascode with the fifth and the sixth transistor respectively, the arrangement also including a bias circuit for biassing the gate electrodes of the third and the fourth transistor at a voltage which is substantially equal to the sum of one threshold voltage and two saturation voltages, said bias circuit including a ninth transistor of the first conductivity type whose source electrode is coupled to the first supply terminal and whose gate electrode is coupled to the common gate electrode of the third and fourth transistor and to its drain electrode, characterized in that the drain electrode of the ninth transistor is coupled to the second supply terminal by means of a second current source.

2. An amplifier arrangement as claimed in Claim 1, characterized in that a tenth transistor of the first conductivity type is arranged in series with the ninth transistor, the gate electrode of the ninth transistor being coupled to the gate electrode and to the drain electrode of the tenth transistor.

3. An amplifier arrangement as claimed in Claim 1 or 2, characterized in that the gate electrodes of the seventh and the eighth transistor are coupled together and in that an eleventh transistor of the second conductivity type is arranged between the common terminal of the source electrodes of the fifth and the sixth transistor and the common gate electrode of the seventh and the eighth transistor, the drain of the eleventh transistor being connected to the eleventh transistor's gate electrode and to the first supply terminal by means of a third current source.

4. An amplifier arrangement as claimed in Claim 3, characterized in that a twelfth transistor of the first conductivity type is arranged in series with the eleventh transistor, said twelfth transistor having its source electrode coupled to the common gate electrode of the seventh and the eighth transistor and having its gate electrode coupled to the second supply terminal.

5. An amplifier arrangement as claimed in Claim 3 or 4, characterized in that the third current source is constituted by a thirteenth transistor of the first conductivity type whose source electrode is coupled to the first supply terminal and whose gate electrode is coupled to the gate electrode of the ninth transistor.

6. An amplifier arrangement as claimed in Claim 1 or 2, characterized in that the arrangement is formed as an integrated circuit on a substrate of a first conductivity type in which the fifth and the sixth transistor are arranged in a zone of a second conductivity type which is connected to the second supply terminal and in which the seventh and the eighth transistor are arranged in separate zones of the second conductivity type which are connected to the drain electrodes of the fifth and the sixth transistor, respectively, and in that the gate electrodes of the seventh and eighth transistor are connected to the gate electrodes of the fifth and the sixth transistor, respectively.

7. An amplifier arrangement as claimed in Claim 1 or 2, characterized in that the arrangement is formed as an integrated circuit on a substrate of a first conductivity type in which the fifth and the sixth transistor are arranged in a zone of the second conductivity type which is connected to the second supply terminal and in which the seventh and the eight transistor are arranged in a common zone of the second conductivity type which is connected to the common terminal of the source electrodes of the fifth and the sixth transistor, and in that the gate electrodes of the seventh and the eight transistsor are connected to the gate electrode of the fifth and the sixth transistor, respectively.

8. An amplifier arrangement as claimed in Claim 1 or 2, characterized in that the arrangement is formed as an integrated circuit on a substrate of a first conductivity type in which the fifth and the sixth transistor are arranged in a zone of a second conductivity type which is connected to the second supply terminal and in which the seventh and the eighth transistor are arranged in a common zone of the second conductivity type which is connected to the common terminal of the source electrodes of the fifth and the sixth transistor, and in that the gate electrode of the seventh transistor is connected to the gate electrode of the eighth transistor and to the gate electrode of the fifth transistor.

## Ansprüche

1. Verstärkeranordnung, die einen Differenzverstärker mit zwei Eingangsklemmen zum Empfangen einer Eingangsspannung und einen Differenz-Eintakt-Wandler mit einer Ausgangsklemme zum Liefern eines Ausgangsstroms enthält, wobei der Wandler einen ersten und einen zweiten Transistor von einem ersten Leitfähigkeitstyp, deren Quellenelektroden an eine erste Speiseklemme und deren Gate-Elektroden aneinander gekoppelt sind, und einen dritten und einen vierten Transistor vom ersten Leitfähigkeitstyp in Kaskodenschaltung mit dem ersten bzw. dem zweiten Transistor und mit einer Kopplung ihrer Gate-Elektroden enthält, wobei die Gate-Elektrode des ersten Transistors mit der Abzugselektrode des dritten Transistors gekoppelt ist, und der Differenzverstärker einen fünften und einen sechsten Transistor von einem zweiten, den ersten Leitfähigkeitstyp entgegengesetzten Leitfähigkeitstyp, deren Gate-Elektroden mit den Eingangsklemmen und deren Quellenelektroden mit einer gemeinsamen Klemme gekoppelt sind, die über eine erste Stromquelle mit einer zweiten Speiseklemme gekoppelt ist, und einen siebten und einen achten Transistor vom zweiten Leitfähigkeitstyp enthält, die mit dem fünften bzw. sechsten Transistor kaskodengeschaltet sind, wobei die Anordnung ebenfalls eine Vorspannungsschaltung zum Vorspannen der Gate-Elektroden des dritten und des vierten Transistors auf einer Spannung enthält, die im wesentlich gleich der Summe einer Schwellenspannung und von zwei Sättigungsspannungen ist, wobei die Vorspannungsschaltung einen neunten Transistor vom ersten Leitfähigkeitstyp enthält, dessen Quellenelektrode mit der ersten Speiseklemme und dessen Gate-Elektrode mit der gemeinsamen Gate-Elektrode des dritten und des vierten Transistors sowie mit seiner Abzugselektrode gekoppelt ist, dadurch gekennzeichnet, daß die Abzugselektrode des neunten Transistors über eine zweite Stromquelle mit der zweiten Speiseklemme gekoppelt ist.

2. Verstärkeranordnung nach Anspruch 1, dadurch gekennzeichnet, daß ein zehnter Transistor vom ersten Leitfähigkeitstyp mit dem neunten Transistor in Reihe geschaltet ist, wobei die Gate-Elektrode des neunten Transistors mit der Gate-Elektrode und mit der Abzugselektrode des zehnten Transistors gekoppelt ist.

3. Verstärkeranordnung nach Anspruch 1 oder 2, dadurch gekennzeichnet, daß die Gate-Elektroden des siebten und des achten Transistors miteinander gekoppelt sind, und daß ein elfter Transistor vom zweiten Leitfähigkeitstyp zwischen der gemeinsamen Klemme der Quellenelektroden des fünften und des sechsten Transistors und der gemeinsamen Gate-Elektrode des siebten und des achten Transistors angeordnet sind, wobei der Abzug des elften Transistors an die Gate-Elektrode des elften Transistors und über eine dritte Stromquelle an die erste Speiseklemme angeschlossen ist.

4. Verstärkeranordnung nach Anspruch 3, dadurch gekennzeichnet, daß ein zwölfter Transistor vom ersten Leitfähigkeitstyp mit dem elften Transistor in Reihe geschaltet ist, wobei die Quellenelektrode des zwölften Transistors mit der gemeinsamen Gate-Elektrode des siebten und des achten Transistors und seine Gate-Elektrode mit der zweiten Speiseklemme gekoppelt sind.

5. Verstärkeranordnung nach Anspruch 3 oder 4, dadurch gekennzeichnet, daß die dritte Stromquelle aus einem dreizehnten Transistor vom ersten Leitfähigkeitstyp besteht, dessen Quellenelektrode mit der ersten Speiseklemme und dessen Gate-Elektrode mit der Gate-Elektrode des neunten Transistors gekoppelt sind.

6. Verstärkeranordnung nach Anspruch 1 oder 2, dadurch gekennzeichnet, daß die Anordnung als integrierte Schaltung auf einem Substrat von einem ersten Leitfähigkeitstyp ausgebildet ist, in der der fünfte und der sechste Transistor in einer Zone von einem zweiten Leitfähigkeitstyp angeordnet sind, die an die zweite Speiseklemme angeschlossen ist, und in der der siebte und der achte Transistor in getrennten Zonen vom zweiten Leitfähigkeitstyp angeordnet sind, die an die Abzugselektroden des fünften bzw. des sechsten Transistors angeschlossen sind, und daß die Gate-Elektroden des siebten und des achten Transistors an die Gate-Elektroden des fünften bzw. des sechsten Transistors angeschlossen sind.

7. Verstärkeranordnung nach Anspruch 1 oder 2, dadurch gekennzeichnet, daß die Anordnung als integrierte Schaltung auf einem Substrat von einem ersten Leitfähigkeitstyp ausgebildet ist, in der der fünfte und der sechste Transistor in einer Zone vom zweiten Leitfähigkeitstyp angeordnet sind, die an die zweite Speiseklemme angeschlossen ist, und in der der siebte und der achte Transistor in einer gemeinsamen Zone vom zweiten Leitfähigkeitstyp angeordnet sind, die an die gemeinsame Klemme der Quellenelektroden des fünften bzw. des sechsten Transistors angeschlossen sind, und daß die Gate-Elektroden des siebten und des achten Transistors an die Gate-Elektrode des fünften bzw. des sechsten Transistors angeschlossen sind.

8. Verstärkeranordnung nach Anspruch 1 oder 2, dadurch gekennzeichnet, daß die Anordnung als integrierte Schaltung auf einem Substrat von einem ersten Leitfähigkeitstyp ausgebildet ist, in der der fünfte und der sechste Transistor in einer Zone vom zweiten Leitfähigkeitstyp angeordnet sind, die an die zweite Speiseklemme angeschlossen ist, und in der der siebte und der achte Transistor in einer gemeinsamen Zone vom zweiten Leitfähigkeitstyp angeordnet sind, die an die gemeinsame Klemme der Quellenelektroden des fünften bzw. des sechsten Transistors angeschlossen sind, und daß die Gate-Elektrode des siebten Transistors an die Gate-Elektrode des achten Transistors sowie an die Gate-Elektrode des fünften Transistors angeschlossen ist.

## Revendications

1. Circuit d'amplification comportant un amplificateur différentiel présentant deux bornes d'entrée pour la réception d'une tension d'entrée et un convertisseur différentiel-unilatéral présentant une borne de sortie pour délivrer un courant de sortie, ledit convertisseur étant muni d'un premier transistor et d'un deuxième transistor d'un premier type de conductivité dont les électrodes de source sont couplées à une première borne d'alimentation et dont les électrodes de porte sont couplées entre elles, et d'un troisième transistor et d'un quatrième transistor du premier type de conductivité disposés en cascode avec respectivement les premier et deuxième transistors dont les électrodes de porte sont couplées entre elles, l'électrode de porte du premier transistor étant couplée à l'électrode de drain du troisième transistor, ledit amplificateur différentiel étant muni d'un cinquième transistor et d'un sixième transistor d'un deuxième type de conductivité opposé au premier type de conductivité, dont les électrodes de porte sont couplées aux bornes d'entrée et dont les électrodes de source sont couplées à une borne commune qui est couplée à l'aide d'une première source de courant à une deuxième borne d'alimentation, et d'un septième transistor et d'un huitième transistor du deuxième type de conductivité qui sont disposés en cascode avec respectivement les cinquième et sixième transistors, le circuit comportant également un circuit de polarisation pour la polarisation des électrodes de porte des troisième et quatrième transistors à une tension qui est pratiquement égale à la somme d'une tension de seuil et de deux tensions de saturation, ledit circuit de polarisation comportant un neuvième transistor du premier type de conductivité dont l'électrode de source est couplée à la première borne d'alimentation et dont l'électrode de porte est couplée à l'électrode de porte commune des troisième et quatrième transistors et à son électrode de drain, caractérisé en ce que l'électrode de drain du neuvième transistor est couplée à la deuxième borne d'alimentation à l'aide d'une deuxième source de courant.

2. Circuit d'amplification selon la revendication 1, caractérisé en ce qu'un dixième transistor du premier type de conductivité est monté en série avec le neuvième transistor, l'électrode de porte du neuvième transistor étant couplée à l'électrode de porte et à l'électrode de drain du dixième transistor.

3. Circuit d'amplification selon la revendication 1 ou 2, caractérisé en ce que les électrodes de porte des septième et huitième transistors sont couplées entre elles et en ce qu'un onzième transistor du deuxième type de conductivité est disposé entre la borne commune des électrodes de source des cinquième et sixième transistors et l'électrode de porte commune des septième et huitième transistors, le drain du onzième transistor étant connecté à l'électrode de porte du onzième transistor et à la première borne d'alimentation à l'aide d'une troisième source de courant.

4. Circuit d'amplification selon la revendication 3, caractérisé en ce qu'un douzième transistor du premier type de conductivité est monté en série avec le onzième transistor, douzième transistor dont l'électrode de source est couplée à l'électrode de porte commune des septième et huitième transistors et dont l'électrode de porte est couplée à la deuxième borne d'alimentation.

5. Circuit d'amplification selon la revendication 3 ou 4, caractérisé en ce que la troisième source de courant est constituée par un treizième transistor du premier type de conductivité dont l'électrode de source est couplée à la première borne d'alimentation et dont l'électrode de porte est couplée à l'électrode de porte du neuvième transistor.

6. Circuit d'amplification selon la revendication 1 ou 2, caractérisé en ce que le circuit est formé comme un circuit intégré sur un substrat d'un premier type de conductivité dans lequel les cinquième et sixième transistors sont disposés dans une zone d'un deuxième type de conductivité qui est connectée à la deuxième borne d'alimentation et dans lequel les septième et huitième transistors sont disposés dans des zones séparées du deuxième type de conductivité qui sont connectées aux électrodes de drain respectivement des cinquième et sixième transistors et en ce que les électrodes de porte des septième et huitième transistors sont connectées aux électrodes de porte respectivement des cinquième et sixième transistors.

7. Circuit d'amplification selon la revendication 1 ou 2, caractérisé en ce que le circuit est sous forme d'un circuit intégré sur un substrat d'un premier type de conductivité dans lequel les cinquième et sixième transistors sont disposés dans une zone du deuxième type de conductivité qui est connectée à la deuxième borne d'alimentation et dans lequel les septième et huitième transistors sont disposés dans une zone commune du deuxième type de conductivité qui est connectée à la borne commune des électrodes de source des cinquième et sixième transistors, et en ce que les électrodes de porte des septième et huitième transistors sont connectées à l'électrode de porte respectivement des cinquième et sixième transistors.

8. Circuit d'amplification selon la revendication 1 ou 2, caractérisé en ce que le circuit est sous forme d'un circuit intégré sur un substrat d'un premier type de conductivité dans lequel les cinquième et sixième transistors sont disposés dans une zone d'un deuxième type de conductivité qui est connectée à la deuxième borne d'alimentation et dans lequel les septième et huitième transistors sont disposés dans une zone commune du deuxième type de conductivité qui est connectée à la borne commune des électrodes de source des cinquième et sixième transistors, et en ce que l'électrode de porte du septième transistor est connectée à l'électrode de porte du huitième transistor et à l'électrode de porte du cinquième transistor.

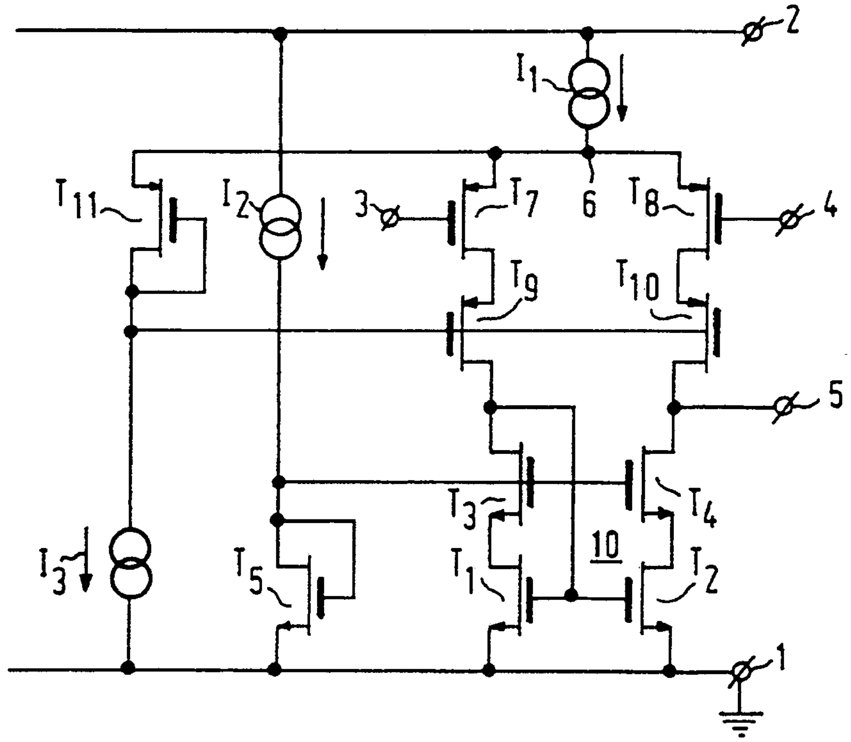
2
I1
T11
I2
3
T7
6
T8
4
T9
T10
5
T3
T4
I3
T5
10
T1
T2
1

FIG.1

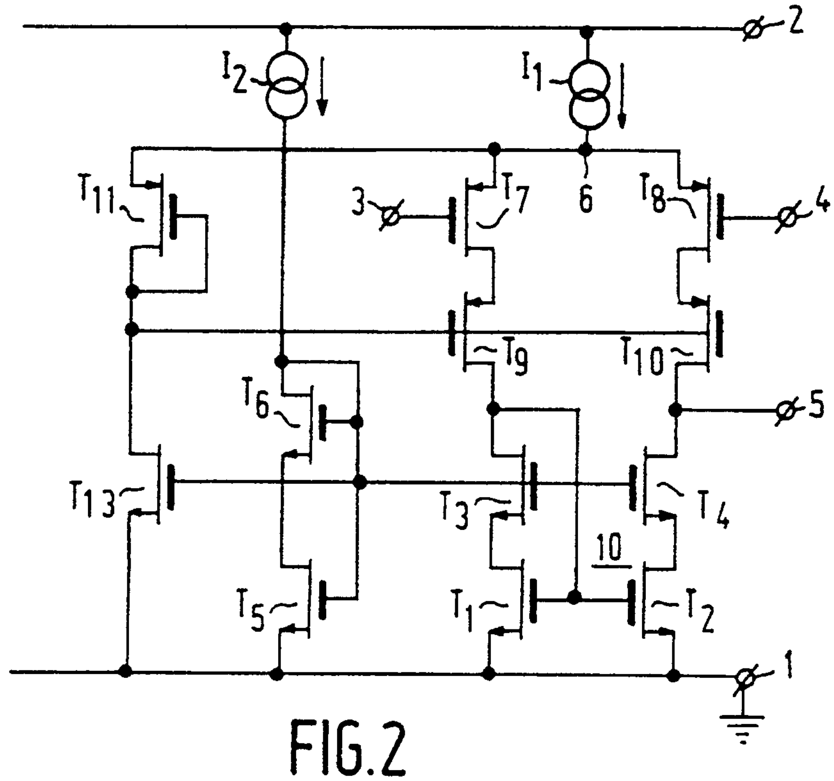
2
I2
I1
T11
3
T7
6
T8
4
T9
T10
T6
5
T13
T3
T4
10
T5
T1
T2
1

FIG.2

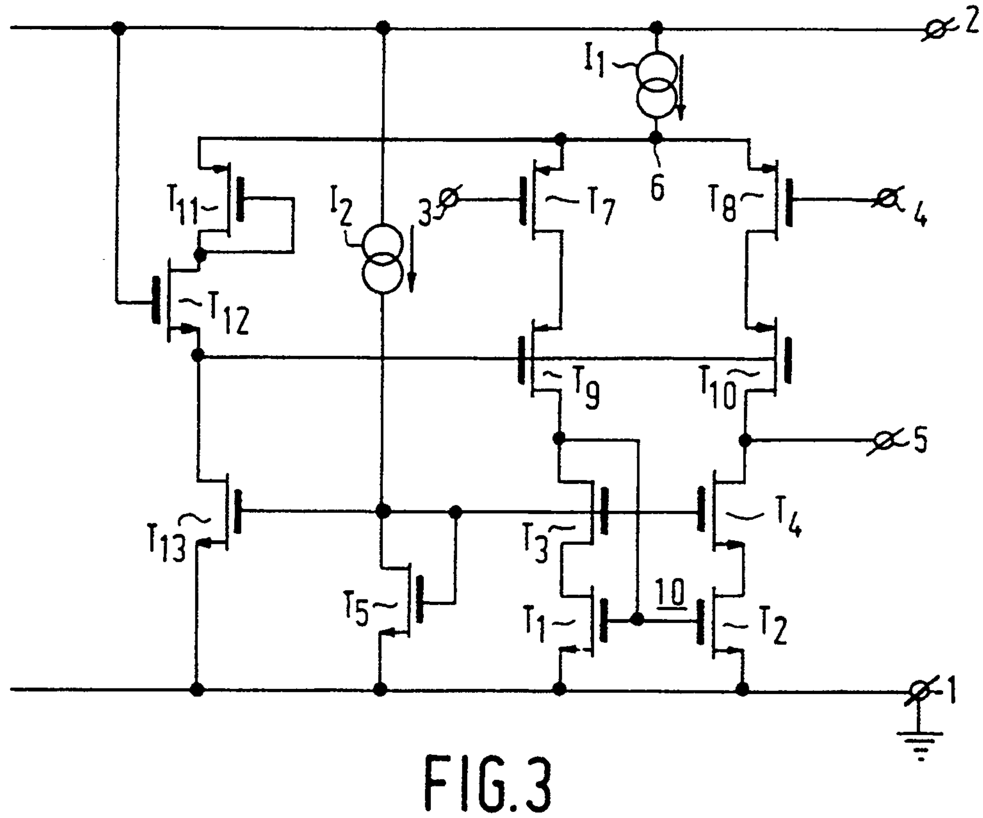
2
$I_1$
6
$T_{11}$
$T_7$
$T_8$
3
4
$I_2$
$T_{12}$
$T_9$
$T_{10}$
5
$T_{13}$
$T_3$
$T_4$
$T_5$
10
$T_1$
$T_2$
1

FIG.3

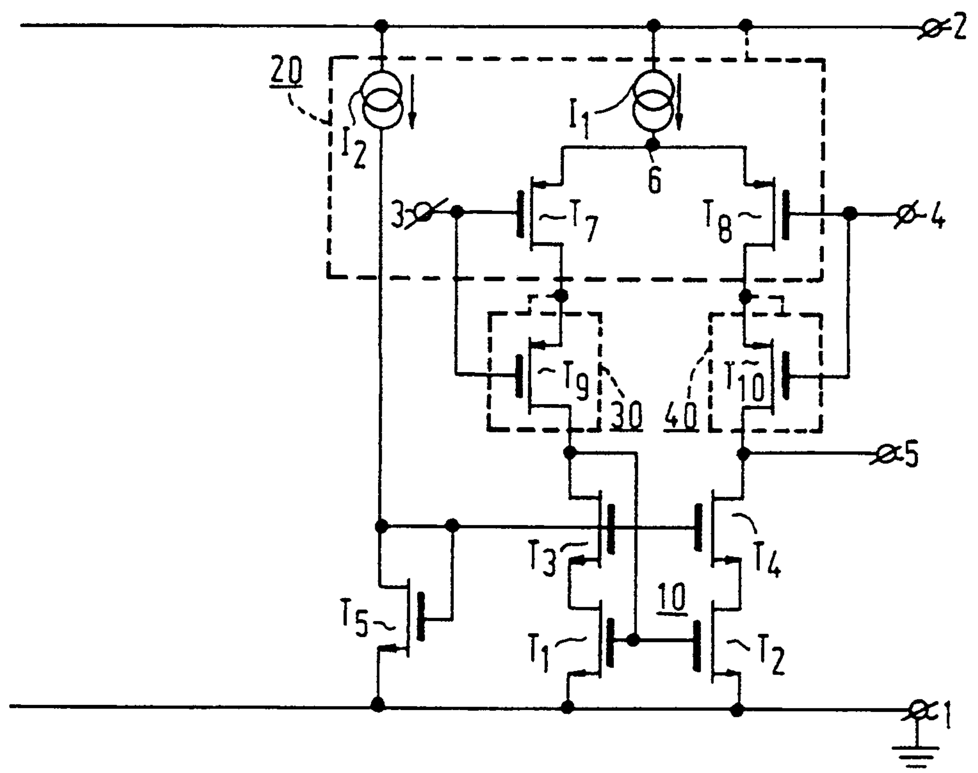
2
20
$I_2$
$I_1$
6
3
$T_7$
$T_8$
4
$T_9$
30
40
$T_{10}$
5
$T_3$
$T_4$
$T_5$
10
$T_1$
$T_2$
1

FIG.4

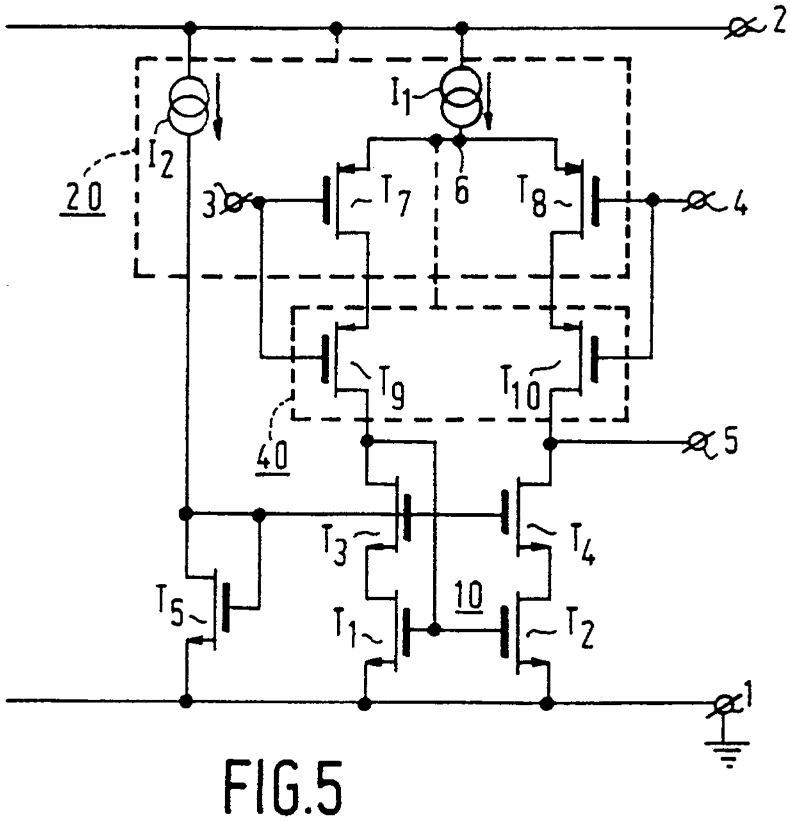
2
I1
I2
20
3
T7
6
T8
4
T9
T10
40
5
T3
T4
T5
10
T1
T2
1

FIG.5

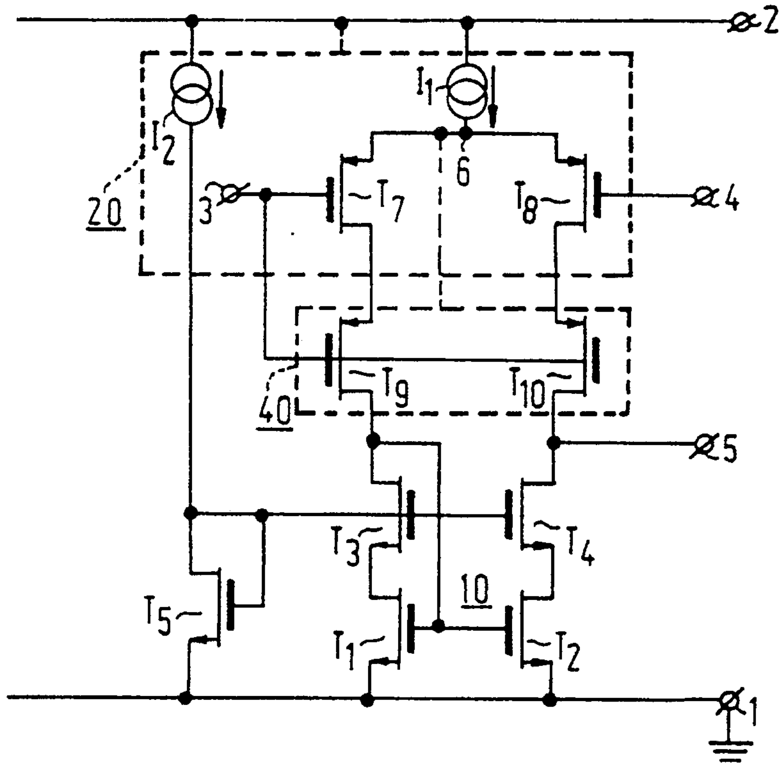
2
I1
I2
20
3
T7
6
T8
4
T9
T10
40
5
T3
T4
T5
10
T1
T2
1

FIG.6